# EUROPEAN PATENT APPLICATION

(11) **EP 4 403 946 A1**
(43) Date of publication of application: **24.07.2024**
(21) Application number: 24152358.8
(22) Date of filing: 17.01.2024
(51) Int. Cl.: G01R 33/48, G01R 33/54, G01R 33/56, G01R 33/565

(54) **MAGNETIC RESONANCE IMAGING APPARATUS AND CHEMICAL-SHIFT PEAK DETECTION METHOD**

(30) Priority: 18.01.2023 JP 2023005606
(71) Applicant: Canon Medical Systems Corporation, Tochigi 324-0036 (JP)
(72) Inventor: TAKI, Sotaro, Otawara-shi, 324-0036 (JP); TOMIHA, Sadanori, Otawara-shi, 324-0036 (JP); YUI, Masao, Otawara-shi, 324-0036 (JP)
(74) Representative: Marks & Clerk LLP

(57) **Abstract**

An MRI apparatus (100) according to one embodiment includes an obtaining unit (136) obtains information about a contrast agent containing substances with mutually different chemical shifts; a determiner unit (138) determines, based on the information, a frequency band related to a decrease in a MR signal due to the chemical shifts; an acquirer unit (121) acquires, prior to contrast enhancement using the contrast agent, a first MR signal group in the frequency band by CEST imaging under different saturation pulse conditions; and acquire, after the contrast enhancement using the contrast agent, a second MR signal group in the frequency band by CEST imaging under different saturation pulse conditions; a calculator unit (140) calculates a difference between a first Z-spectrum generated based on the first MR signal group and a second Z-spectrum generated based on the second MR signal group; and a detector unit (142) detects, from the difference, peaks indicating the decrease in the MR signal due to the chemical shifts of the substances

## Description

### FIELD

Embodiments described herein relate generally to a magnetic resonance imaging apparatus and a chemical-shift peak detection method.

### BACKGROUND

Traditionally, magnetic resonance imaging (MRI) techniques based on chemical exchange saturation transfer (hereinafter, CEST) have been presented. Chemical exchange occurs between solute protons in a water pool and water protons. For example, protons of compounds such as amide (-NH), hydroxyl (-OH), and amino (-NH2) groups are exchangeable protons. Such chemical exchange rate depends on temperature and pH. Meanwhile, the resonance frequency of the protons vary depending on their state, which is referred to as chemical shift. As such, transmission of a radiofrequency (RF) saturation pulse at a frequency particular to the solute protons causes a phenomenon that saturation is transferred from the solute protons to the water protons, which are supposed to be unsaturated. Such a phenomenon is referred to as chemical exchange saturation transfer (CEST). CEST-based imaging techniques are referred to as CEST imaging. Examples of the CEST-based imaging include an MR imaging technique based on chemical exchange between protons of amide (-NH), hydroxyl (-OH), and amino (-NH2) groups and free water protons. Substances that cause CEST phenomenon (hereinafter, referred to as CEST substances) are used in CEST imaging.

CEST phenomenon reflects substance properties such as temperature and pH, as described above. In other words, the chemical exchange rate in CEST phenomenon depends on temperature and pH. Thus, CEST imaging can be used for temperature and pH measurements. For example, pH imaging independent of the concentration of a CEST substance is feasible by combining a CEST substance with two proton pools and a ratiometric method. The pH calculation by the ratiometric method uses, for example, signal values of two proton pools at two peaks in a Z-spectrum showing the influence of CEST effects and signal values used for normalization of the signal values in the Z-spectrum. A magnetic resonance imaging method based on the CEST effects (hereafter referred to as CEST imaging) is performed to obtain data for use in Z-spectrum generation.

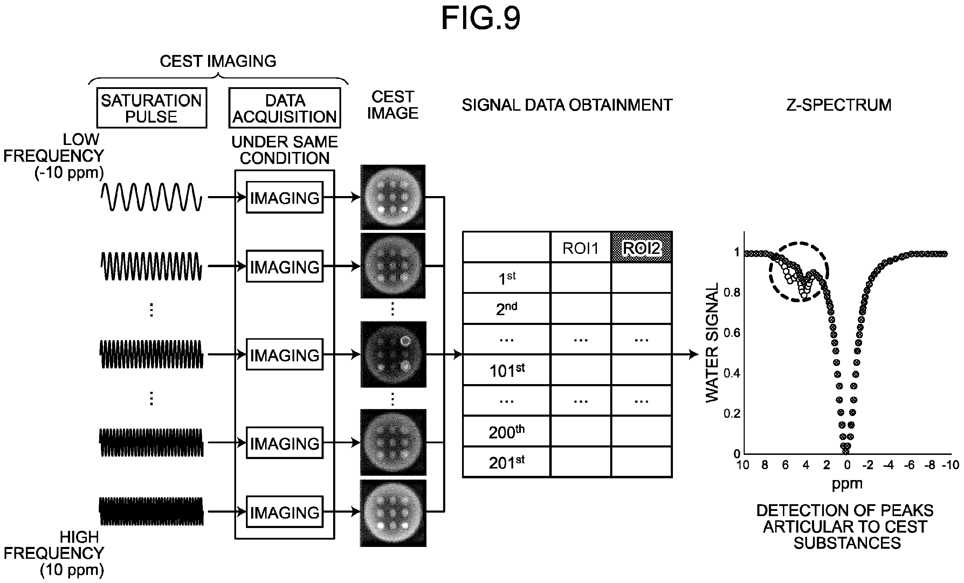

FIG. 9 shows an example of an overview of traditional CEST imaging, Z-spectrum generation, and peak detection of a CEST substance. The CEST substance shown in FIG. 9 is iopamidol, which corresponds to two kinds of substances, i.e., two amide groups having a chemical shift of 4.2 ppm and one amide group having a chemical shift of 5.6 ppm. In FIG. 9, multiple saturation pulse frequencies used in CEST imaging are in the range of -10 ppm to 10 ppm by increments of 0.1 ppm. At a static magnetic field strength of 3T, for example, the saturation pulse frequency at zero ppm matches the free-water resonance frequency (hereinafter, referred to as center frequency) based on a static field strength, i.e., 128 MHz. The saturation pulse frequency at +10 ppm is found as (128 MHz + 128 × 10 Hz). The saturation pulse frequency at -10 ppm is found as (128 MHz - 128 × 10 Hz).

As shown in FIG. 9, by CEST imaging, MR images (CEST images) are obtained by applying saturation pulses at frequencies from -10 ppm to +10 ppm by increments of 0.1 ppm, with the center frequency defined as zero ppm. Signal data is obtained from pixel values in a region of interest (ROI) (ROI1 and ROI2 in FIG. 9) on 201 MR images. A Z-spectrum is generated based on the signal data. A signal value (peak) at the chemical shift (ppm) of the CEST substance is then detected from the Z-spectrum.

As shown in FIG. 9, it is disadvantageous that traditional CEST imaging requires a longer imaging time because of acquisition of as many as 201 CEST images. In addition, multiple Z-spectra are generated to obtain a Z-spectrum with less noise, which further increases the length of imaging time. As shown in FIG. 9, to detect the two peaks of the CEST substances in the Z-spectrum, the Z-spectrum is to be subject to fitting by five approximations, i.e., two approximations for the two peaks of the two CEST substances, an approximation for the peak of water, an approximation for magnetization transfer (MT) effects, and an approximation for Overhauser effects, taking all of natural proton pools in vivo into account. Such fitting by the five approximations is time-consuming, complicated computations and may be less accurate. In addition, the initial parameter values of the five approximations differ depending on the tissue for which the Z-spectrum is generated. It is thus necessary to set the initial values in accordance with the tissue.

### SUMMARY OF THE INVENTION

A magnetic resonance imaging apparatus includes an obtaining unit configured to obtain information about a contrast agent containing a plurality of substances with mutually different chemical shifts; a determiner unit configured to determine, based on the information, a frequency band related to a decrease in a magnetic resonance signal due to the chemical shifts; an acquirer unit configured to acquire, prior to contrast enhancement using the contrast agent, a first magnetic resonance signal group in the frequency band by chemical exchange saturation transfer "CEST" imaging under different saturation pulse conditions; and acquire, after the contrast enhancement using the contrast agent, a second magnetic resonance signal group in the frequency band by CEST imaging under different saturation pulse conditions; a calculator unit configured to calculate a difference between a first Z-spectrum generated based on the first magnetic resonance signal group and a second Z-spectrum generated based on the second magnetic resonance signal group; and a detector unit configured to detect, from the difference, peaks indicating the decrease in the magnetic resonance signal due to the chemical shifts of the plurality of substances.

The determiner unit may determine the frequency band using a B₀ map generated prior to the CEST imaging.

The detector unit may detect the peaks by function fitting to a signal-value distribution in the difference or by estimating an approximate form of the signal-value distribution.

The determiner unit may determine, based on the information, a frequency being outside the frequency band and irrelevant of the decrease in the magnetic resonance signal due to the chemical shifts. The acquirer unit may acquire reference MR signals to be a basis of the first Z-spectrum and the second Z-spectrum, by using the determined frequency as a saturation pulse or without using any saturation pulse. The first Z-spectrum may be generated based on the first magnetic resonance signal group and the reference MR signals. The second Z-spectrum may be generated based on the second magnetic resonance signal group and the reference MR signals.

The calculator unit may calculate a state quantity in an imaging region with respect to the first Z-spectrum and the second Z-spectrum according to the peaks and the reference MR signals.

The state quantity may represent a temperature or pH in the imaging region.

A chemical-shift peak detection method includes obtaining information about a contrast agent containing a plurality of substances with mutually different chemical shifts; determining, based on the information, a frequency band related to a decrease in a magnetic resonance signal due to the chemical shifts; acquiring, prior to contrast enhancement using the contrast agent, a first magnetic resonance signal group in the frequency band by chemical exchange saturation transfer (CEST) imaging under different saturation pulse conditions; acquiring, after the contrast enhancement using the contrast agent, a second magnetic resonance signal group in the frequency band by CEST imaging under different saturation pulse conditions; calculating a difference between a first Z-spectrum generated based on the first magnetic resonance signal group and a second Z-spectrum generated based on the second magnetic resonance signal group; and detecting, from the difference, peaks indicating the decrease in the magnetic resonance signal due to the chemical shifts of the plurality of substances.

### BRIEF DESCRIPTION OF THE DRAWINGS

FIG. 1 is a schematic block diagram illustrating an exemplary configuration of a magnetic resonance imaging apparatus according to an embodiment;
FIG. 2 is a flowchart illustrating an exemplary state-quantity determining procedure according to an embodiment;
FIG. 3 illustrates an example of a non-contrast Z-spectrum according to an embodiment;
FIG. 4 illustrates an example of a contrast Z-spectrum according to an embodiment;
FIG. 5 illustrates an example of a differential spectrum according to an embodiment;
FIG. 6 illustrates an example of applying function fitting to a differential spectrum according to an embodiment;
FIG. 7 illustrates an example of a differential spectrum after integration according to an embodiment;
FIG. 8 illustrates an exemplary effect of an embodiment; and
FIG. 9 illustrates an overview of traditional CEST imaging, Z-spectrum generation, and peak detection of CEST substances, as an example.

### DETAILED DESCRIPTION

A magnetic resonance imaging apparatus according to one embodiment includes processing circuitry and sequence control circuitry. The processing circuitry is configured to obtain information about a contrast agent containing a plurality of substances with mutually different chemical shifts, and determine, based on the information, a frequency band related to a decrease in magnetic resonance signal due to the chemical shifts. The sequence control circuitry is configured to acquire, prior to contrast enhancement using the contrast agent, a first magnetic resonance signal group in the frequency band by chemical exchange saturation transfer (CEST) imaging under different saturation pulse conditions, and acquire, after the contrast enhancement using the contrast agent, a second magnetic resonance signal group in the frequency band by CEST imaging under different saturation pulse conditions. The processing circuitry is further configured to calculate a difference between a first Z-spectrum generated based on the first magnetic resonance signal group and a second Z-spectrum generated based on the second magnetic resonance signal group, and detect, from the difference, peaks indicating the decrease in the magnetic resonance signal due to the chemical shifts of the plurality of substances.

Hereinafter, exemplary embodiments of a magnetic resonance imaging (MRI) apparatus and a chemical-shift peak detection method will be described in detail with reference to the accompanying drawings. The following embodiments are presented for illustrative purposes only and not to be construed as limiting. In principle, descriptions and details of one embodiment are applicable to another embodiment. Throughout the following embodiments, parts, portions, elements, or functions denoted by the same reference numerals are considered to perform same or similar operation, and an overlapping explanation thereof will be omitted when appropriate.

### Embodiment

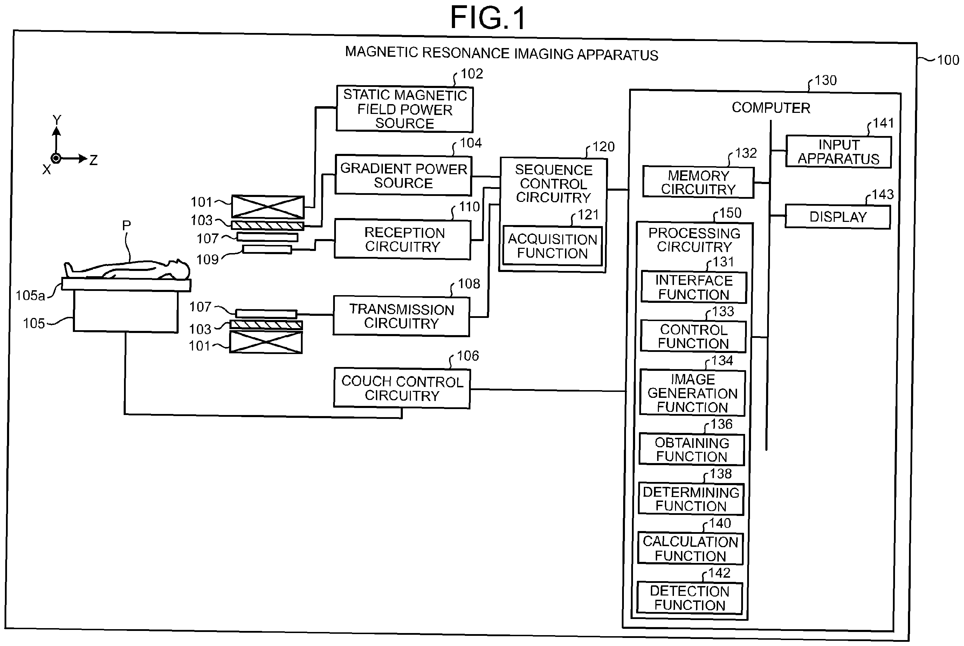

FIG. 1 is a block diagram of an exemplary configuration of an MRI apparatus 100 according to an embodiment. As illustrated in FIG. 1, the MRI apparatus 100 includes a static magnetic field magnet 101, a static magnetic field power source 102, gradient coils 103, a gradient power source 104, a couch 105, couch control circuitry 106, transmission coils 107, transmission circuitry 108, a reception coil 109, reception circuitry 110, sequence control circuitry 120, and a computer (also referred to as image processing apparatus) 130. The MRI apparatus 100 does not include a subject P (such as a human body). The structure and configuration illustrated in FIG. 1 are merely exemplary. As an example, the elements of both the sequence control circuitry 120 and the computer 130 may be integrated or separated when appropriate. The computer 130 can be incorporated in a console, for example.

The static magnetic field magnet 101 is hollow, substantially cylindrical magnets to generate static magnetic fields in the internal space. Example of the static magnetic field magnet 101 includes a superconducting magnet that magnetizes, supplied with a current from the static magnetic field power source 102. The static magnetic field power source 102 supplies currents to the static magnetic field magnet 101. The static magnetic field power source 102 may be separated from the MRI apparatus 100. The static magnetic field magnet 101 can be permanent magnets. In this case the MRI apparatus 100 may not include the static magnetic field power source 102.

The gradient coils 103 have hollow, substantially cylindrical shapes respectively and located inside the static magnetic field magnet 101. Each gradient coil 103 is a combination of three coils corresponding to mutually orthogonal X-axis, Y-axis, and Z-axis. The three coils are individually supplied with currents from the gradient power source 104, to generate gradient magnetic fields that vary in field strength along the X, Y, and Z-axes. The gradient magnetic fields generated along the X, Y, and Z-axes by the gradient coils 103 are exemplified by a slice gradient magnetic field Gs, a phase-encoding gradient magnetic field Ge, and a readout gradient magnetic field Gr. The gradient power source 104 supplies currents to the gradient coils 103.

The couch 105 includes a couchtop 105a on which the subject P is to be laid. Under the control of the couch control circuitry 106, the couch 105 with the subject P lying thereon is inserted into a hollow space (imaging region) of the gradient coils 103. The couch 105 is typically installed such that its longitudinal side is parallel to the axes of the static magnetic field magnet 101. The couch control circuitry 106 serves to drive the couch 105 to move the couchtop 105a longitudinally and vertically under the control of the computer 130.

The transmission coils 107 are located inside the gradient coils 103, to generate high-frequency magnetic fields, supplied with an RF pulse from the transmission circuitry 108. The transmission circuitry 108 supplies RF pulses corresponding to the Larmor frequency to the transmission coils 107. The Larmor frequency is defined by a type of target atoms and a magnetic field strength.

The reception coil 109 is located inside the gradient coils 103, to receive magnetic resonance (MR) signals which are issued from the subject P due to an influence of the high-frequency magnetic field. The reception coil 109 outputs the MR signals to the reception circuitry 110 upon receipt.

The transmission coils 107 and the reception coil 109 as described above are merely exemplary. Each of the transmission coils 107 and the reception coil 109 may be one or a combination of a coil having a transmission function alone, a coil having a reception function alone, and a coil having both transmission and reception functions.

The reception circuitry 110 serves to detect MR signals output from the reception coil 109 and generate MR data from the detected MR signals. Specifically, the reception circuitry 110 generates MR data by converting the MR signals output from the reception coil 109 into digital signals. The reception circuitry 110 transmits the MR data to the sequence control circuitry 120. The reception circuitry 110 may be included in a gantry apparatus equipped with the static magnetic field magnet 101 and the gradient coils 103.

The sequence control circuitry 120 includes an acquisition function 121. The acquisition function 121 serves to perform imaging of the subject P by driving the gradient power source 104, the transmission circuitry 108, and the reception circuitry 110 based on sequence information transmitted from the computer 130. Herein, the sequence information is information representing defined imaging procedures and is also referred to as a sequence condition. The sequence information includes definitions of current intensity and current supply timing from the gradient power source 104 to the gradient coils 103, RF pulse intensity and RF pulse application timing from the transmission circuitry 108 to the transmission coils 107, and MR-signal detection timing by the reception circuitry 110, for example.

Examples of the sequence control circuitry 120 include integrated circuitry such as an application specific integrated circuit (ASIC) and a field programmable gate array (FPGA), and electronic circuitry such as a central processing unit (CPU) and a micro processing unit (MPU). The sequence control circuitry 120 corresponds to a sequence control unit. The sequence control circuitry 120 implementing the acquisition function 121 corresponds to an acquirer unit.

The acquisition function 121 acquires a first magnetic resonance signal group in the frequency band determined by a later-described determining function 138 under different saturation pulse conditions, by CEST imaging of the subject P before injection of a contrast agent (contrast substance) (hereinafter, referred to as CEST non-contrast imaging). The acquisition function 121 also acquires a second magnetic resonance signal group in the frequency band determined by the determining function 138 under different saturation pulse conditions, by CEST imaging of the subject P after the injection of the contrast agent (hereinafter, referred to as CEST contrast imaging). Any known sequences are applicable to the CEST non-contrast and contrast imaging sequences, except for use of the saturation pulse frequencies in the frequency band as determined above, therefore, a description thereof is omitted. Explanations of CEST imaging and frequency bands will be presented later. The acquisition function 121 drives the gradient power source 104, the transmission circuitry 108, and the reception circuitry 110 to image the subject P. The acquisition function 121 then receives resultant MR data from the reception circuitry 110 and transfers the MR data to the computer 130.

The computer 130 performs overall control of the MRI apparatus 100 and generates images, for example. The computer 130 includes memory circuitry 132, an input apparatus 141, a display 143, and processing circuitry 150. The processing circuitry 150 includes an interface function 131, a control function 133, an image generation function 134, an obtaining function 136, a determining function 138, a calculation function 140, and a detection function 142.

Processing and functions to be performed by the interface function 131, the control function 133, the image generation function 134, the obtaining function 136, the determining function 138, the calculation function 140, and the detection function 142 are stored in the memory circuitry 132 in the form of a computer program executable by the computer 130. The processing circuitry 150 is a processor that retrieves and executes the computer programs from the memory circuitry 132 to implement the functions corresponding to the respective computer programs. In other words, after retrieving the computer programs, the processing circuitry 150 includes the respective functions shown in the processing circuitry 150 of FIG. 1.

FIG. 1 depicts an example that the single piece of processing circuitry 150 implements the processing and functions of the interface function 131, the control function 133, the image generation function 134, the obtaining function 136, the determining function 138, the calculation function 140, and the detection function 142. Alternatively, the processing circuitry 150 may be constituted of a combination of independent processors so that the processors can individually implement the functions by executing the computer programs. In other words, the above functions may be configured as individual computer programs to be executed by the single piece of processing circuitry 150, or particular function or functions may be incorporated in dedicated, independent program-executable circuitry.

The term "processor" used herein signifies, for example, circuitry such as a CPU, a graphical processing unit (GPU), an application specific integrated circuit, a programmable logic device (e.g., simple programmable logic device (SPLD)), a complex programmable logic device (CPLD), and a field programmable gate array (FPGA). The processor retrieves and executes the computer programs from the memory circuitry 132 to implement the functions.

In place of being stored in the memory circuitry 132, the computer programs may be directly embedded in the circuitry of the processor. In such a case the processor retrieves and executes the computer programs from the circuitry to implement the functions. Likewise, the couch control circuitry 106, the transmission circuitry 108, the reception circuitry 110, and the sequence control circuitry 120 each include electronic circuitry such as the above processor.

The memory circuitry 132 stores therein MR data as received by the interface function 131 of the processing circuitry 150, various kinds of data obtained by the obtaining function 136, various kinds of image data generated by the image generation function 134, computations for use in the calculation function 140, differences calculated by the computations, detection processing for use in the detection function 142, and multiple peaks determined by the detection function 142, for example.

The memory circuitry 132 further stores MR data arranged by the control function 133 in k-space (also referred to as k-space data). These various types of stored data will be explained later. The memory circuitry 132 can be implemented by, for example, a semiconductor memory device such as a random access memory (RAM) or a flash memory, a hard disc, or an optical disc. The memory circuitry 132 may be referred to as a memory.

The input apparatus 141 serves to receive various kinds of instructions and information inputs from the user. Examples of the input apparatus 141 include a trackball, a switch button, a mouse, a keyboard, a touchpad that allows input by touch on the operation surface, a touch screen as an integration of a display screen and a touchpad, a non-contact input circuit including an optical sensor, and a voice input circuit. The input apparatus 141 is electrically connected to the processing circuitry 150 to convert user inputs into electrical signals and outputs them to the processing circuitry 150.

In this disclosure, the input interface 43 is not limited to the one including physical operational component or components (input interface) as a mouse and a keyboard. Other examples of the input interface 43 include electrical-signal processing circuitry that receives an electrical signal corresponding to an input from an external input interface separated from the MRI apparatus 100 to output the electrical signal to control circuitry. The input interface 43 corresponds to an input unit and may be referred to as an input interface.

The display 143 displays a graphical user interface (GUI) to allow the user to input imaging conditions and else as well as displays images generated by the image generation function 134 of the processing circuitry 150 under the control of the control function 133 of the processing circuitry 150. Examples of the display 143 include a cathode ray tube (CRT) display, a liquid crystal display (LCD), an organic electroluminescence display (OELD), a light-emitting diode (LED) display, a plasma display, any of other displays known in related art, and a display device as a monitor.

Hereinafter, an example of CEST imaging of the present embodiment will be explained. In CEST imaging, the sequence control circuitry 120 applies a saturation pulse being a frequency-selective radio frequency (RF) pulse to the subject P at the resonance frequency of exchangeable protons (e.g., protons of a compound) before acquisition of MR signals. The exchangeable-proton resonance frequency is an off-resonance frequency far from the free water resonance frequency. The saturation pulse is also referred to as a pre-saturation pulse. CEST imaging refers to a magnetic resonance imaging technique for applying multiple saturation pulses and acquiring multiple magnetic resonance (MR) signals responsive to the multiple saturation pulses. The respective saturation pulse frequencies for use in CEST imaging are determined by the determining function 138 as described below. The interval between every two adjacent saturation pulse frequencies is defined as 0.1 ppm herein although it is not limited to 0.1 ppm. The interval between the two adjacent saturation pulse frequencies can be freely set as long as the Z-spectrum clearly exhibiting the CEST phenomenon can be obtained.

For the sake of specificity, multiple substances (CEST substances: proton pools) that cause the CEST phenomenon are defined to be contained in the contrast agent. In other words, the contrast agent contains multiple substances (functional groups) with mutually different chemical shifts. In the case of using iopamidol as the contrast agent, for example, iopamidol contains two substances (two types of amide groups) with mutually different chemical shifts. Specifically, the two substances contained in iopamidol correspond to two kinds of substances, i.e., two amide groups with a chemical shift of 4.2 ppm and one amide group with a chemical shift of 5.6 ppm. In the present embodiment the contrast agent is not limited to iopamidol, and any contrast agent is applicable as long as it contains multiple CEST substances with mutually different chemical shifts.

The processing circuitry 150 uses the interface function 131 to transmit sequence information to the sequence control circuitry 120 and receive MR data from the sequence control circuitry 120. Upon receipt of MR data, the interface function 131 of the processing circuitry 150 stores the MR data in the memory circuitry 132. The processing circuitry 150 implementing the interface function 131 corresponds to an interface unit.

The processing circuitry 150 uses the control function 133 to control the MRI apparatus 100 as a whole and control imaging, image generation, and image display. For example, the processing circuitry 150 uses the control function 133 to receive an input of an imaging condition (imaging parameters, etc.) via the GUI and to generate sequence information according to a saturation pulse condition set by the received imaging condition. The processing circuitry 150 uses the control function 133 to transmit the generated sequence information to the sequence control circuitry 120.

For example, the control function 133 transmits, to the sequence control circuitry 120, CEST-imaging sequence information including multiple saturation pulse frequencies in the frequency band determined by the determining function 138 and sequence information as to MR imaging to acquire MR data for generation of B₀ maps (hereinafter, map imaging). The processing circuitry 150 implementing the control function 133 corresponds to a control unit.

The processing circuitry 150 uses the image generation function 134 to generate images by retrieving k-space data from the memory circuitry 132 and subjecting the k-space data to reconstruction processing such as Fourier transformation. For example, the image generation function 134 generates a B₀ map from the MR data acquired by map imaging (hereinafter, referred to as mapped MR data). The B₀ map represents inhomogeneity of the static magnetic field (B₀) in the imaging region. The image generation function 134 stores the generated B₀ map in the memory circuitry 132. The B₀ map can be suitably generated by any of known methods, therefore, a description thereof is omitted. The processing circuitry 150 implementing the image generation function 134 corresponds to an image generator unit.

The processing circuitry 150 uses the image generation function 134 to generate a first Z-spectrum based on the first magnetic resonance signal group. Specifically, the image generation function 134 generates multiple MR images (hereinafter, referred to as non-contrast enhanced MR images) based on the first magnetic resonance signal group (non-contrast enhanced data) acquired by CEST imaging before contrast enhancement (no contrast). The image generation function 134 generates a first Z-spectrum (non-contrast Z-spectrum) based on the non-contrast enhanced MR images and the B₀ map, while correcting the position of the saturation pulse (hereinafter, referred to as B₀ correction). The B₀ correction may be performed on the non-contrast enhanced MR images. In this case, the image generation function 134 generates the first Z-spectrum based on multiple non-contrast enhanced MR images having undergone the B₀ correction. The first Z-spectrum is normalized using the reference MR signal, as described below. Thus, the first Z-spectrum is generated based on the first magnetic resonance signal group and the reference MR signal. The Z-spectrum generation can be implemented by any of known methods, therefore, a description thereof is omitted. The B₀ correction may be omissible.

The processing circuitry 150 uses the image generation function 134 to generate a second Z-spectrum based on the second magnetic resonance signal group. Specifically, the image generation function 134 generates multiple MR images (hereinafter, referred to as contrast enhanced MR images) based on the second magnetic resonance signal group (contrast enhanced data) acquired by CEST imaging after contrast enhancement. The image generation function 134 generates a second Z-spectrum (contrast Z-spectrum) based on the contrast enhanced MR images and the B₀ map while performing B₀ correction. The B₀ correction may be performed on the contrast enhanced MR images. In this case, the image generation function 134 generates the second Z-spectrum based on the B₀ corrected, contrast enhanced MR images. The second Z-spectrum is normalized using the reference MR signal, as described below. Thus, the second Z-spectrum is generated based on the second magnetic resonance signal group and the reference MR signal.

The first and second Z-spectra are normalized using the reference MR signal after the position of the saturation pulse in CEST imaging is corrected based on the B₀ map generated by imaging different from CEST imaging. The first Z-spectrum and the second Z-spectrum may be generated by the calculation function 140.

The processing circuitry 150 uses the obtaining function 136 to obtain information about a contrast agent containing a plurality of substances with mutually different chemical shifts. Specifically, the obtaining function 136 obtains the contrast-agent information provided by a user input via the input apparatus 141. The contrast-agent information represents, for example, multiple chemical shifts (ppm) of multiple CEST substances (substances causing the CEST phenomenon). In response to a user input of a contrast agent name via the input apparatus 141, the obtaining function 136 obtains contrast-agent information through comparison between the contrast agent name and a correspondence table stored in the memory circuitry 132. The correspondence table corresponds to, for example, a look-up table containing contrast agent names and chemical shifts (ppm) in association with each other. The processing circuitry 150 implementing the obtaining function 136 corresponds to an obtaining unit.

The processing circuitry 150 uses the determining function 138 to determine a frequency band related to a decrease in MR signal due to a chemical shift, based on the information obtained by an obtaining function 146. The frequency band corresponds to a frequency domain of saturation pulses centered on each of the chemical shifts and related to the decrease in MR signal due to the CEST phenomenon of each of the CEST substances. The frequency band (frequency domain) is a certain range set in the order of ppm with the water saturation frequency defined as zero ppm, and has a certain width around a unique value (chemical shift) determined depending on the components of the contrast agent. For example, with chemical shifts of 4.2 ppm and 5.6 ppm, the determining function 138 determines a band including a predetermined frequency range centered on 4.2 ppm and 5.6 ppm as the frequency band. The predetermined frequency range is, for example, set to ±1 ppm. The predetermined frequency range is not limited to ±1 ppm, and can be set freely as long as the range is related to the decrease in MR signal due to the CEST phenomenon of each of the CEST substances.

Instead of the predetermined frequency range, the determining function 138 may use the number n of saturation pulse applications along the direction of +ppm or -ppm around each of the chemical shifts. For example, when n = 10, the interval between two adjacent saturation pulse frequencies is set to 0.1 ppm, so that the frequency range will be the same as above.

The determining function 138 may additionally use the B₀ map generated prior to CEST imaging, to determine the frequency band. Specifically, the determining function 138 determines the average of B₀ values corresponding to pixels in a ROI for Z-spectrum generation or the median of the B₀ values as the water resonance frequency (0 ppm). The determining function 138 then determines the frequency band based on the determined water resonance frequency.

Based on the information obtained by the obtaining function 146, the determining function 138 may determine a frequency (hereinafter, reference frequency) being outside the determined frequency band and unrelated to, irrespective of, or less relevant to the decrease in the magnetic resonance signal due to the chemical shift. The MR signals are acquired by application of the reference frequency as a saturation pulse (hereinafter, reference MR signal) and used to normalize the signal values of the contrast Z-spectrum and the signal values of the non-contrast Z-spectrum.

Specifically, the determining function 138 determines, as the reference frequency, a frequency that is unsusceptible to disturbances due to the water saturation frequency, the chemical shifts of the CEST substances, MT effects, and Overhauser effects. For example, the determining function 138 determines, as the reference frequency, a frequency corresponding to -20 ppm and being greater absolute value in ppm than ±10 ppm (i.e., farther than ±10 ppm). Alternatively, the determining function 138 may determine the frequency corresponding to the position where the number n of pulse applications exceeds 10, as the reference frequency. With no application of saturation pulses to acquire the reference MR signals, the reference-frequency determination by the determining function 138 is omissible.

After the determining function 138 determines the reference frequency, the sequence control circuitry 120 uses the acquisition function 121 to acquire, before injection of the contrast agent into the subject P, the reference MR signals to be a basis of the first Z-spectrum and the second Z-spectrum, using the determined reference frequency as a saturation pulse. With no reference frequency determined by the determining function 138, the sequence control circuitry 120 uses the acquisition function 121 to acquire the reference MR signals before injection of the contrast agent into the subject P, without using any saturation pulse. The acquisition of the reference MR signals may be implemented by CEST contrast imaging or by different imaging from CEST contrast imaging. The processing circuitry 150 implementing the determining function 138 corresponds to a determiner unit.

The processing circuitry 150 uses the calculation function 140 to calculate the difference between the first Z-spectrum generated based on the first magnetic resonance signal group and the second Z-spectrum generated based on the second magnetic resonance signal group. For example, the calculation function 140 obtains the difference (hereinafter, referred to as a differential spectrum) by subtracting the second Z-spectrum from the first Z-spectrum. The calculation function 140 calculates a state quantity in the imaging region (e.g., ROI) with respect to the first Z-spectrum and the second Z-spectrum based on the reference MR signals and the multiple peaks detected by the detection function 142. The state quantity is, for example, a temperature or pH in the imaging region. The pH or temperature calculation is in line with the computation procedure (e.g., ratiometric method) disclosed, for example, in "K. M. Ward and R. S. Balaban, Determination of pH Using Water Protons and Chemical Exchange Dependent Saturation Transfer (CEST), Magnetic Resonance in Medicine 44:799-802 (2000)", therefore, a description thereof is omitted. The calculation function 140 stores the resultant state quantity in the memory circuitry 132. The control function 133 may display the state quantity on the display 143, for example. The processing circuitry 150 implementing the calculation function 140 corresponds to a calculator unit.

The processing circuitry 150 uses the detection function 142 to detect peaks, indicating decrease in the magnetic resonance signal due to the chemical shifts of the substances, from the calculated difference. In other words, the detection function 142 detects, from the difference, multiple peaks indicating decreases in the magnetic resonance signal arising from the chemical shifts of the respective CEST substances. Specifically, the detection function 142 detects the peaks by function fitting to a signal-value distribution in the difference or by estimating an approximate form of such a distribution. More specifically, the detection function 142 detects the peaks of the two CEST substances by function fitting to the signal-value distribution using two approximations for the peaks of the two CEST substances. In place of the function fitting, the detection function 142 may detect the peaks by an approximate-form estimation (peak-value estimation) of the signal-value distribution. Any of known methods is suitably applicable to the function fitting and approximate-form estimation, therefore, a description thereof is omitted. The processing circuitry 150 implementing the detection function 142 corresponds to a detector unit.

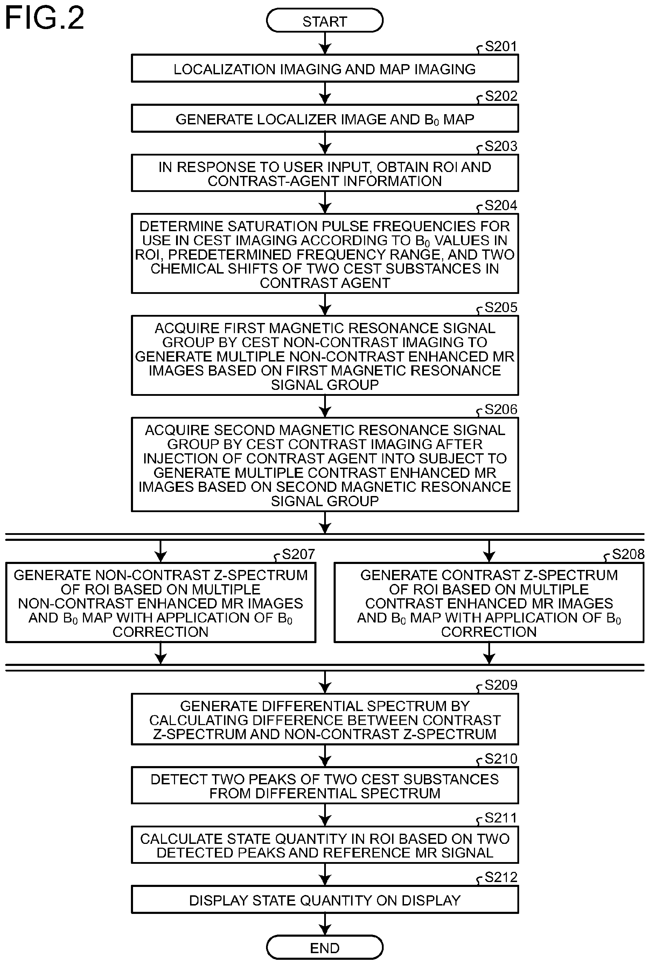

The overall configuration and structure of the MRI apparatus 100 according to some embodiments have been described above. With such configuration and structure, the MRI apparatus 100 of some embodiments performs CEST non-contrast imaging, map imaging, and CEST contrast imaging to calculate the peaks of multiple chemical shifts of multiple substances using the MR data acquired by the three types of imaging, and determines a state quantity according to the multiple peaks and the reference MR signals (hereinafter, state-quantity determining process). A state-quantity determining procedure will be described below with reference to FIG. 2. FIG. 2 is a flowchart illustrating an example of the state-quantity determining procedure.

For the sake of specificity, the static magnetic field strength is defined as 3T, the predetermined frequency range is defined as 1 ppm, and iopamidol is used as a contrast agent. The two CEST substances are two kinds of substances, i.e., two amide groups with a chemical shift of 4.2 ppm and one amide group with a chemical shift of 5.6 ppm. The water saturation pulse frequency at 0 ppm, i.e., center frequency, is defined as 128 MHz. The sequence information as to map imaging is preset. The sequence information as to CEST non-contrast imaging and as to CEST contrast imaging is also preset except for multiple saturation pulse frequencies. Any of known methods is applicable to the sequence information setting, therefore, a description thereof is omitted. In the state-quantity determining process, the same object is subject to CEST non-contrast imaging, map imaging, and CEST contrast imaging. In other words, the same region of interest is subject to CEST non-contrast imaging, map imaging, and CEST contrast imaging.

### State-Quantity Determining Process

### Step S201

The sequence control circuitry 120 performs localization imaging and map imaging to the subject P in response to a user instruction given via the input apparatus 141. Localization imaging includes locator imaging and high-speed, ROI-setting imaging. Map imaging may also include B1 shimming. Other preliminary imaging may be performed in step S201. The acquisition function 121 acquires MR data by localization imaging (hereinafter, MR localizer data). The acquisition function 121 also acquires mapped MR data by map imaging.

### Step S202

The image generation function 134 generates a localizer image based on the MR localizer data. The control function 133 displays the localizer or locator image on the display 143. The image generation function 134 generates a B₀ map based on the mapped MR data. The control function 133 stores the B₀ map in the memory circuitry 132.

### Step S203

In accordance with a user instruction given via the input apparatus 141, the obtaining function 136 obtains the location of a ROI on the locator image and contrast-agent information. Through step S203, the location of the ROI for the state-quantity determination and the chemical shifts of the CEST substances contained in the contrast agent are obtained. The obtaining function 136 stores the location of the ROI and the chemical shifts in the memory circuitry 132 in association with each other. Specifically, the obtaining function 136 obtains two chemical shifts (4.2 ppm and 5.6 ppm) of iopamidol.

### Step S204

The determining function 138 determines a frequency band (multiple saturation pulses frequencies) for use in CEST imaging according to the B₀ values in the ROI, the predetermined frequency range, and the two chemical shifts of the two CEST substances in the contrast agent. Specifically, the determining function 138 determines the B₀ value corresponding to the ROI location with reference to the stored ROI location and the B₀ map. The determining function 138 retrieves the predetermined frequency range from the memory circuitry 132. The determining function 138 determines the frequency band of the saturation pulses for use in CEST imaging, based on the predetermined frequency range and the two chemical shifts of the two CEST substances. The determining function 138 determines saturation pulse frequencies based on the determined B₀ value and frequency band. The determining function 138 determines a reference frequency outside the frequency band based on the two chemical shifts of the two CEST substances in the contrast agent. The determining function 138 stores the determined reference frequency and saturation pulse frequencies in the memory circuitry 132.

### Step S205

The sequence control circuitry 120 performs CEST non-contrast imaging of the subject P in response to a user instruction given via the input apparatus 141. The acquisition function 121 acquires a first magnetic resonance signal group by CEST non-contrast imaging. The acquisition function 121 also acquires the reference MR signals corresponding to the reference frequency. The acquisition function 121 stores the first magnetic resonance signal group and the reference MR signals in the memory circuitry 132. The image generation function 134 generates multiple non-contrast enhanced MR images based on the first magnetic resonance signal group. The image generation function 134 stores the non-contrast enhanced MR images in the memory circuitry 132.

### Step S206

After injection of the contrast agent into the subject P, the sequence control circuitry 120 performs CEST contrast imaging of the subject P in response to a user instruction given via the input apparatus 141. The acquisition function 121 acquires a second magnetic resonance signal group by CEST contrast imaging. The acquisition function 121 also acquires the reference MR signals corresponding to the reference frequency. The acquisition function 121 stores the second magnetic resonance signal group and the reference MR signals in the memory circuitry 132. The image generation function 134 generates multiple contrast enhanced MR images based on the second magnetic resonance signal group. The image generation function 134 stores the contrast enhanced MR images in the memory circuitry 132. The sequence control circuitry 120 may perform various types of imaging during a period until when the contrast agent is accumulated in the tissue of interest (e.g., 15 to 60 minutes). For example, in the period from immediately after injection of the contrast agent into the subject P to a start of CEST contrast imaging, the sequence control circuitry 120 may perform any kind of imaging, such as localization imaging according to an examination order, second-time map imaging, imaging to obtain a T1-weighted image, imaging to obtain a T2-weighted image, and echo planar imaging (EPI).

### Step S207

The image generation function 134 generates a non-contrast Z-spectrum (first Z-spectrum) of the ROI based on the multiple non-contrast enhanced MR images and the B₀ map with application of the B₀ correction to the non-contrast enhanced MR images. The image generation function 134 stores the generated non-contrast Z-spectrum in the memory circuitry 132.

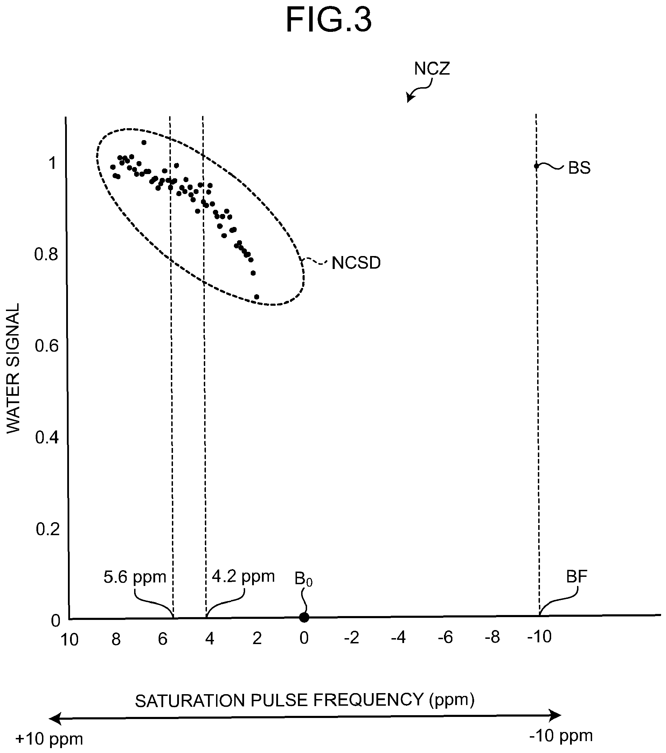

FIG. 3 shows an exemplary non-contrast Z-spectrum NCZ. FIG. 3 shows, in a dotted area NCSD, a signal-value distribution of water with respect to saturation pulse frequencies (ppm) in non-contrast enhancement. The non-contrast Z-spectrum NCZ also exhibits a reference MR signal BS at a reference frequency BF of smaller than -10 ppm.

### Step S208

The image generation function 134 generates a contrast Z-spectrum (second Z-spectrum) of the ROI based on the multiple contrast enhanced MR images and the B₀ map with application of the B₀ correction to the contrast enhanced MR images. The image generation function 134 stores the generated contrast Z-spectrum in the memory circuitry 132.

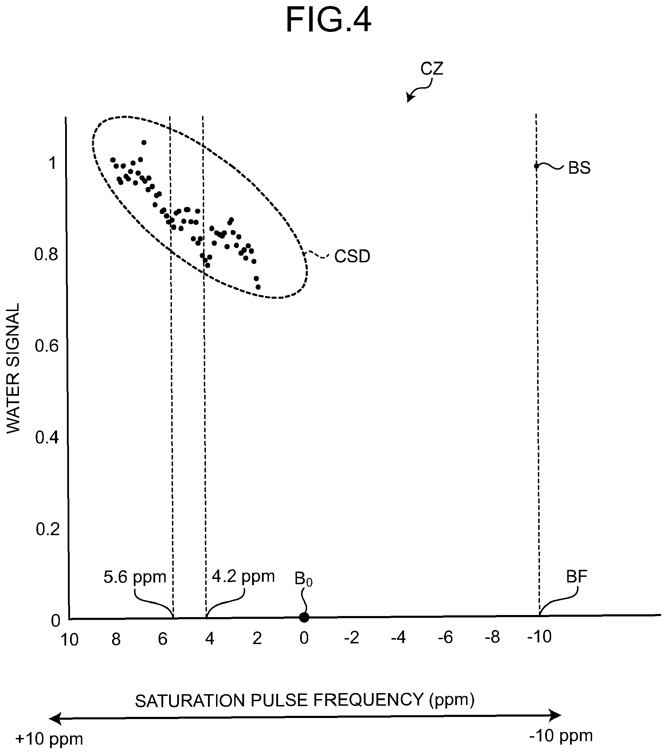

FIG. 4 shows an exemplary contrast Z-spectrum CZ. FIG. 4 shows, in a dotted area CSD, a signal-value distribution of water relative to saturation pulse frequencies (ppm) in the contrast Z-spectrum CZ. The contrast Z-spectrum CZ also exhibits a reference MR signal BS at a reference frequency BF of smaller than -10 ppm. In the contrast Z-spectrum CZ, B₀ at zero ppm indicates the frequency determined by B₀ correction. In acquiring the reference MR signals BS by either CEST contrast imaging or CEST non-contrast imaging, both the non-contrast Z-spectrum NCZ and the contrast Z-spectrum CZ do not exhibit the reference MR signal BS, for example.

### Step S209

The calculation function 140 generates a differential spectrum by calculating the difference between the contrast Z-spectrum CZ and the non-contrast Z-spectrum NCZ. Specifically, the calculation function 140 generates a differential spectrum by subtracting the contrast Z-spectrum CZ from the non-contrast Z-spectrum NCZ. The calculation function 140 stores the generated differential spectrum in the memory circuitry 132.

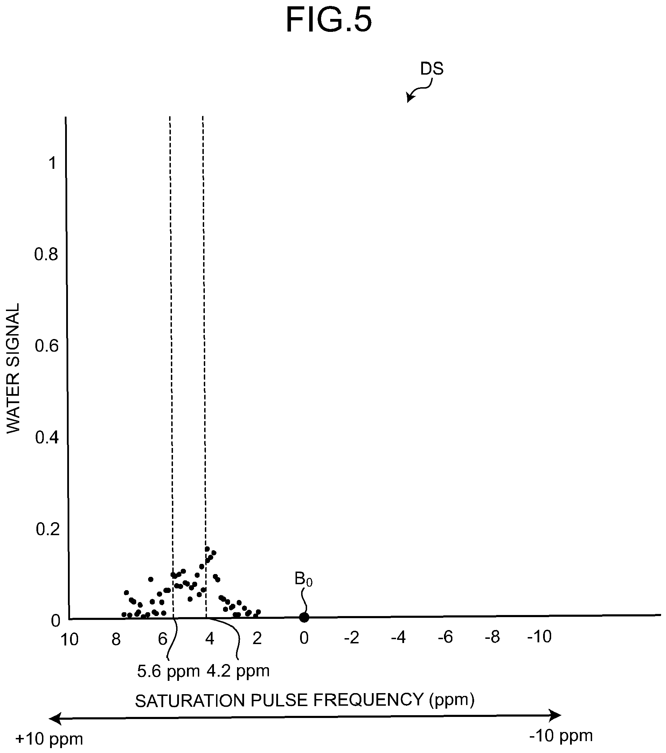

FIG. 5 shows an exemplary differential spectrum DS. As shown in FIG. 5, the differential spectrum DS exhibits a signal-value distribution of water with two chemical shift peaks (4.2 ppm and 5.6 ppm) of iopamidol.

### Step S210

The detection function 142 detects two peaks of the two CEST substances from the differential spectrum DS. For example, the detection function 142 performs function fitting to or approximate-form estimation of the signal-value distribution in the differential spectrum DS. In this manner, the detection function 142 detects the two peaks of the two CEST substances in the differential spectrum DS. The detection function 142 stores the two detected peaks in the memory circuitry 132.

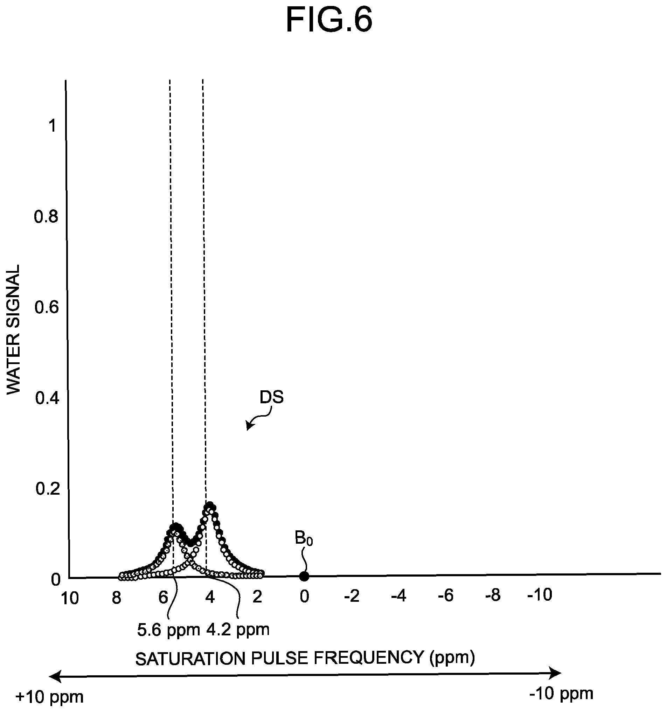

FIG. 6 shows an example of the differential spectrum DS after function fitting is applied. As shown in FIG. 6, the detection function 142 detects peaks at 4.2 and 5.6 ppm by applying the fitting process to the differential spectrum DS using the function representing 4.2 ppm and the function representing 5.6 ppm.

The peak detection is not limited to this example. For example, with respect to two or more differential spectra generated, the detection function 142 integrates signal values at five points, that is, ppm values of two peaks (hereinafter, ppm peaks), a ppm value between adjacent ppm peaks (hereinafter, intermediate ppm), and ppm values at two points (hereinafter, discrete ppm values) apart from each of the two ppm peaks by the distance between the adjacent ppm peaks in the direction opposite to the direction from the two ppm peaks to the intermediate ppm. In other words, the detection function 142 averages the signal values at each of the five points in the differential spectra.

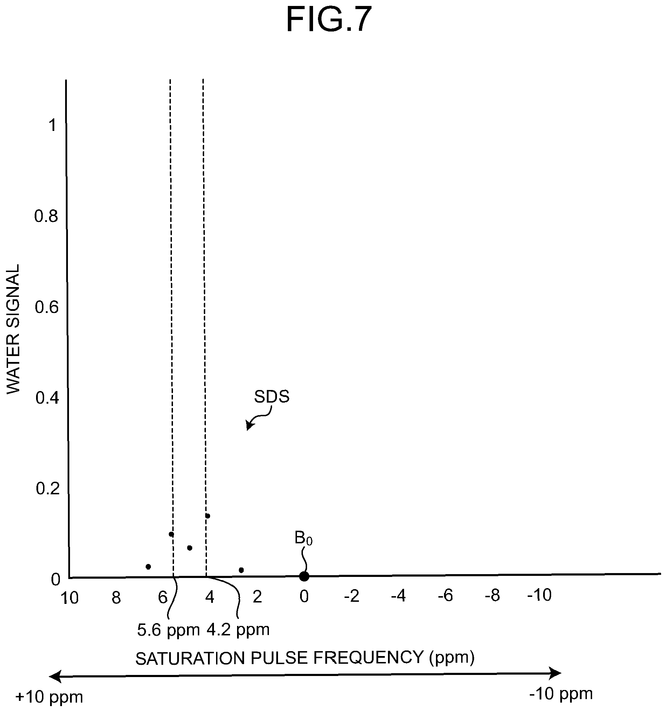

FIG. 7 shows an exemplary differential spectrum SDS after integration. As shown in FIG. 7, with respect to the contrast agent containing two CEST substances corresponding to respectively two peaks, an integrated differential spectrum includes five points. The detection function 142 estimates the signal values of the two peaks in the integrated differential spectrum SDS of FIG. 7. For example, the detection function 142 detects the peaks at 4.2 ppm and 5.6 ppm as a result of function fitting to the five points or an approximate-form estimation of the distribution. The approximate-form estimation refers to substituting, for example, the signal values at the two ppm peaks (4.2 ppm and 5.6 ppm) as maxima, the intermediate ppm (4.9 ppm) as a minimum, and the two discrete ppm values (2.8 ppm and 7.0 ppm) as initial values being adjacent to the contact point with the horizontal axis into the two approximations for the peaks of the two CEST substances, thereby detecting the two peaks.

### Step S211

The calculation function 140 calculates a state quantity in the ROI according to the two detected peaks and the reference MR signal. The calculation function 140 stores the resultant state quantity in the memory circuitry 132.

### Step S212

The control function 133 displays the state quantity on the display 143.

The MRI apparatus 100 according to some embodiments described above obtains information as to a contrast agent containing a plurality of substances with mutually different chemical shifts, and determines, based on the information, a frequency band related to decrease in magnetic resonance signal due to the chemical shifts. Prior to contrast enhancement with the contrast agent, the MRI apparatus 100 acquires a first magnetic resonance signal group in the determined frequency band by chemical exchange saturation transfer (CEST) imaging under different saturation pulse conditions. After contrast enhancement with the contrast agent, the MRI apparatus 100 acquires a second magnetic resonance signal group in the frequency band by CEST imaging under different saturation pulse conditions. The MRI apparatus 100 then calculates the difference between the first Z-spectrum generated based on the first magnetic resonance signal group and the second Z-spectrum generated based on the second magnetic resonance signal group, to detect, from the calculated difference, multiple peaks indicating the chemical shifts of the respective substances and decreases in the magnetic resonance signal.

According to the MRI apparatus 100 of the present embodiment, the first magnetic resonance signal group and the second magnetic resonance signal group correspond to MR signals acquired in a local frequency band relative to the conventional saturation-pulse frequency bands. In the MRI apparatus 100 of the present embodiment, the first Z-spectrum and the second Z-spectrum are also local Z-spectra relative to the conventional Z-spectra (full spectra).

The MRI apparatus 100 of some embodiments further uses the B₀ map generated prior to CEST imaging to determine the frequency band. The MRI apparatus 100 of some embodiments also detects multiple peaks from the calculated difference by function fitting to the signal-value distribution or by estimating an approximate form of the distribution therein. Based on the obtained information, the MRI apparatus 100 according to some embodiments then determines a frequency being outside the determined frequency band and irrespective of the decreases in the magnetic resonance signal due to the chemical shifts, to acquire reference MR signals to be a basis of the first Z-spectrum and the second Z-spectrum by using the determined frequency as a saturation pulse or without using any saturation pulse. The first Z-spectrum is generated based on the first magnetic resonance signal group and the reference MR signals, and the second Z-spectrum is generated based on the second magnetic resonance signal group and the reference MR signals.

The MRI apparatus 100 of some embodiments calculates a state quantity in the imaging region related to the first Z-spectrum and the second Z-spectrum, based on the detected peaks and the reference MR signals. In the MRI apparatus 100 of some embodiments, the state quantity corresponds to a temperature or pH in the imaging region.

Owing to such features, the MRI apparatus 100 of some embodiments can reduce the influence of unconsidered parameters in vivo (such as initial values of the fitting function for each site or region) in the detection of peaks indicating decreases in the signal values of multiple CEST substances, and implement a fitting method which enables a shorter imaging time and less initial conditions. As a result, the MRI apparatus 100 according to some embodiment can significantly reduce the length of computation time for the peak signal values and the amount of data for generation of the Z-spectrum used in the computation, thereby reducing the length of imaging time and improving peak-related data in accuracy at the same time.

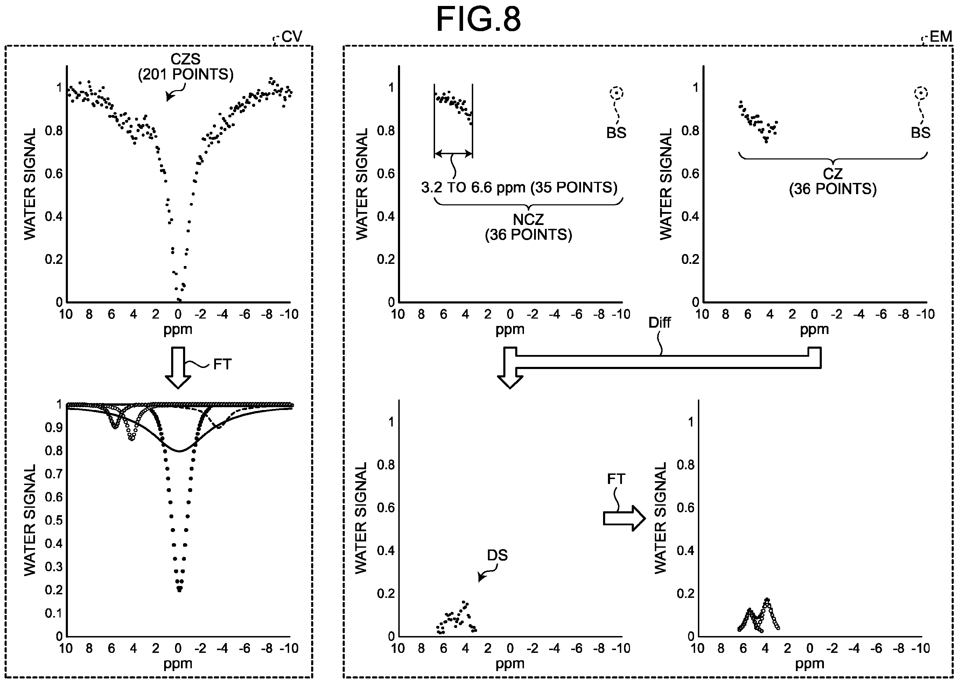

FIG. 8 shows an effect of the present embodiment, as an example. In conventional imaging technique CV, full spectra are obtained in the range of saturation pulse frequencies from -10 ppm to 10 ppm by increments of 0.1 ppm to generate 201 images. In the conventional technique CV, a Z-spectrum CZS is subject to fitting FT by five approximations. Meanwhile, according to the present embodiment EM, the number of images generated can be within (2n + 1 + 1) at the saturation pulse frequencies centered on the chemical shift of each of the two CEST substances. When n = 10, for example, 88 images are acquired in total before and after contrast enhancement. Thus, the MRI apparatus 100 of the present embodiment can perform imaging in about half the time or less than the conventional apparatuses.

In the case of using iopamidol as the contrast agent, as shown in FIG. 8, CEST imaging is performed at 72 points (36 + 36) in total including the reference frequency, centered on the chemical shifts (4.2 ppm and 5.6 ppm) of the two CEST substances, before and after injection of iopamidol. In other words, the MRI apparatus 100 of the present embodiment can decrease the number of times at which imaging is performed to half that of the conventional apparatuses or less. Furthermore, as shown in FIG. 8, a differential spectrum DS is generated from a difference Diff between a non-contrast Z-spectrum NCZ and a contrast Z-spectrum CZ and subject to fitting FT with a less number of boundary conditions and fitting curves, i.e., a decrease from five of the conventional apparatuses to two. Thereby, the fitting can be improved in accuracy and precision.

As described above, the MRI apparatus 100 according to some embodiments can reduce the length of imaging time and the initial conditions (boundary conditions) for fitting and obtain more accurate peak signal values in a shorter period of time than heretofore, to be able to more accurately calculate the state quantity in the ROI in a shorter period of time.

To implement the technical idea of some embodiments by a chemical-shift peak detection method, the chemical-shift peak detection method includes obtaining information about a contrast agent containing a plurality of substances with mutually different chemical shifts; determining, based on the information, a frequency band related to decrease in magnetic resonance signal due to the chemical shifts; acquiring, prior to contrast enhancement using the contrast agent, a first magnetic resonance signal group in the frequency band by chemical exchange saturation transfer (CEST) imaging under different saturation pulse conditions; acquiring, after the contrast enhancement using the contrast agent, a second magnetic resonance signal group in the frequency band by CEST imaging under different saturation pulse conditions; calculating a difference between a first Z-spectrum generated based on the first magnetic resonance signal group and a second Z-spectrum generated based on the second magnetic resonance signal group; and detecting, from the difference, peaks indicating the decrease in the magnetic resonance signal due to the chemical shifts of the plurality of substances. The procedure and effects of the state-quantity determining process including the procedure of the chemical-shift peak detection method are the same as or similar to those of some embodiments, so that a description thereof is omitted.

According to at least one of the embodiments as above, it is possible to shorten the length of imaging time and improve the chemical-shift peak detection in terms of accuracy and precision.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the scope of the inventions as defined by the appended claims.

## Claims

1. A magnetic resonance imaging apparatus (100) comprising:
an obtaining unit (136) configured to obtain information about a contrast agent containing a plurality of substances with mutually different chemical shifts;
a determiner unit (138) configured to determine, based on the information, a frequency band related to a decrease in a magnetic resonance signal due to the chemical shifts;
an acquirer unit (121) configured to acquire, prior to contrast enhancement using the contrast agent, a first magnetic resonance signal group in the frequency band by chemical exchange saturation transfer "CEST" imaging under different saturation pulse conditions; and acquire, after the contrast enhancement using the contrast agent, a second magnetic resonance signal group in the frequency band by CEST imaging under different saturation pulse conditions;
a calculator unit (140) configured to calculate a difference between a first Z-spectrum generated based on the first magnetic resonance signal group and a second Z-spectrum generated based on the second magnetic resonance signal group; and
a detector unit (142) configured to detect, from the difference, peaks indicating the decrease in the magnetic resonance signal due to the chemical shifts of the plurality of substances

2. The magnetic resonance imaging apparatus (100) according to claim 1, wherein
the determiner unit (138) is configured to determine the frequency band using a B₀ map generated prior to the CEST imaging.

3. The magnetic resonance imaging apparatus (100) according to claim 1 or 2, wherein
the detector unit (142) is configured to detect the peaks by function fitting to a signal-value distribution in the difference or by estimating an approximate form of the signal-value distribution.

4. The magnetic resonance imaging apparatus (100) according to any one of claims 1 to 3, wherein
the determiner unit (138) is configured to determine, based on the information, a frequency being outside the frequency band and irrelevant of the decrease in the magnetic resonance signal due to the chemical shifts;
the acquirer unit (121) is configured to acquire reference MR signals to be a basis of the first Z-spectrum and the second Z-spectrum, by using the determined frequency as a saturation pulse or without using any saturation pulse;
the first Z-spectrum is generated based on the first magnetic resonance signal group and the reference MR signals; and
the second Z-spectrum is generated based on the second magnetic resonance signal group and the reference MR signals.

5. The magnetic resonance imaging apparatus (100) according to claim 4, wherein
the calculator unit (140) is further configured to calculate a state quantity in an imaging region with respect to the first Z-spectrum and the second Z-spectrum according to the peaks and the reference MR signals.

6. The magnetic resonance imaging apparatus (100) according to claim 5, wherein
the state quantity represents a temperature or pH in the imaging region.

7. A chemical-shift peak detection method comprising:
obtaining information about a contrast agent containing a plurality of substances with mutually different chemical shifts;
determining, based on the information, a frequency band related to a decrease in a magnetic resonance signal due to the chemical shifts;
acquiring, prior to contrast enhancement using the contrast agent, a first magnetic resonance signal group in the frequency band by chemical exchange saturation transfer (CEST) imaging under different saturation pulse conditions;
acquiring, after the contrast enhancement using the contrast agent, a second magnetic resonance signal group in the frequency band by CEST imaging under different saturation pulse conditions;
calculating a difference between a first Z-spectrum generated based on the first magnetic resonance signal group and a second Z-spectrum generated based on the second magnetic resonance signal group; and
detecting, from the difference, peaks indicating the decrease in the magnetic resonance signal due to the chemical shifts of the plurality of substances.
